(19) 

Europäisches
Patentamt
European
Patent Office
Office européen
des brevets

(11) **EP 4 684 877 A1**

(12) **EUROPEAN PATENT APPLICATION**
published in accordance with Art. 153(4) EPC

(43) Date of publication:
**28.01.2026 Bulletin 2026/05**

(21) Application number: **25768614.7**

(22) Date of filing: **05.03.2025**

(51) International Patent Classification (IPC):
**B01J 37/02** (2006.01)   **B01J 23/83** (2006.01)
**B01J 37/08** (2006.01)   **B01J 23/00** (2006.01)
**C23C 16/455** (2006.01)   **C01B 3/40** (2006.01)

(52) Cooperative Patent Classification (CPC):
**B01J 23/00; B01J 23/83; B01J 37/02; B01J 37/08;
C01B 3/40; C23C 16/455**

(86) International application number:
**PCT/KR2025/002903**

(87) International publication number:
**WO 2025/188058 (11.09.2025 Gazette 2025/37)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **05.03.2024 KR 20240031318
05.03.2024 KR 20240031322**

(71) Applicant: **LG Chem, Ltd.
Seoul 07336 (KR)**

(72) Inventors:
• **KIM, Yongseon
Daejeon 34122 (KR)**
• **KIM, Ki Hwan
Daejeon 34122 (KR)**
• **KIM, Suji
Daejeon 34122 (KR)**
• **KIM, Won Hee
Daejeon 34122 (KR)**

• **KIM, Eui Tae
Daejeon 34122 (KR)**
• **PARK, Sungeun
Daejeon 34122 (KR)**
• **PARK, Seungwon
Daejeon 34122 (KR)**
• **LEE, Geunsung
Daejeon 34122 (KR)**
• **LEE, Eun Jeong
Daejeon 34122 (KR)**
• **JOE, Jemee
Daejeon 34122 (KR)**
• **CHO, Jun Yeon
Daejeon 34122 (KR)**
• **CHOI, Jae Soon
Daejeon 34122 (KR)**

(74) Representative: **Goddar, Heinz J.
Boehmert & Boehmert
Anwaltspartnerschaft mbB
Pettenkoferstrasse 22
80336 München (DE)**

(54) **METHANE-REFORMING CATALYST AND METHOD FOR PRODUCING SAME**

(57)     A method for preparing a catalyst for reforming methane according to an embodiment of the present disclosure comprises: a step of oxidizing the surface of a porous metal support; a step of forming a coating layer 1 containing a first inorganic oxide on the porous metal support with the surface oxidized by ALD (atomic layer deposition), and then preparing a catalyst precursor provided with the coating layer 1 by performing a first heat treatment process; and a step of coating a solution containing a precursor of a perovskite-based compound represented by Chemical Formula 1 on the catalyst precursor provided with the coating layer 1, and then preparing a catalyst provided with a coating layer 2 by performing a second heat treatment process.

EP 4 684 877 A1

【FIG. 1】

**Description**

[Technical Field]

This application claims the priority of Korean Patent Application No. 10-2024-0031318, filed on March 5, 2024 in the Korean Intellectual Property Office, and Korean Patent Application No. 10-2024-0031322, filed on March 5, 2024 in the Korean Intellectual Property Office, the contents of which in their entirety are herein incorporated by reference.

The present disclosure relates to a catalyst for reforming methane and a method for preparing the same.

[Background Art]

As an effort to reduce greenhouse gas to cope with global warming, the carbon dioxide conversion technologies are being researched a lot. Carbon dioxide reforming, which is one of the carbon dioxide conversion technologies, is a technology of obtaining a synthesis gas consisting of hydrogen and carbon monoxide by reacting methane with carbon dioxide.

The synthesis gas is a material with high development value for various downstream raw materials. As a method for industrially obtaining the synthesis gas ($H_2$/CO), the reforming reaction of natural gas may be largely divided into a steam reforming process, a carbon dioxide ($CO_2$) reforming process, a catalytic partial oxidation process, an autothermal reforming process, a tri-reforming process, etc., as shown in Reaction Schemes 1 to 5.

[Reaction Scheme 1] $\quad\quad\quad CH_4 + H_2O \rightarrow 3H_2 + CO \triangle H = 226$ kJ/mol

[Reaction Scheme 2] $\quad\quad\quad CH_4 + CO_2 \rightarrow 2H_2 + 2CO \triangle H = 261$ kJ/mol

[Reaction Scheme 3] $\quad\quad\quad CH_4 + 0.5O_2 \rightarrow 2H_2 + CO \triangle H = -44$ kJ/mol

[Reaction Scheme 4] $\quad\quad\quad$ Autothermal reforming: Reaction Scheme 1 + Reaction Scheme 3

[Reaction Scheme 5] $\quad\quad\quad$ Tri-reforming: Reaction Scheme 1 + Reaction Scheme 2 + Reaction Scheme 3

Meanwhile, various catalysts may be used for reforming activity in the reforming process. Among them, when noble metal catalysts are used in the reforming process, there is an advantage in that the efficiency of converting natural gas into hydrogen is high, but there is a problem in that the economic feasibility is low because the noble metal catalysts are expensive.

Accordingly, nickel catalysts, which exhibit high hydrogen conversion efficiency and are relatively inexpensive, are usually used in the reforming process. However, in such a case, there is a problem in that the nickel catalyst is deactivated by carbon that is inevitably produced on the surface of the nickel catalyst.

Therefore, there is a need in the art for developing a catalyst which is resistant to carbon deposition and can be effectively applied to the reforming process of methane.

**[Disclosure]**

[Technical Problem]

The present disclosure is directed to providing a catalyst for reforming methane and a method for preparing the same.

[Technical Solution]

An embodiment of the present disclosure provides a method for preparing a catalyst for reforming methane, which comprises:

a step of oxidizing the surface of a porous metal support;
a step of forming a coating layer 1 containing a first inorganic oxide on the porous metal support with the surface oxidized by ALD (atomic layer deposition), and then preparing a catalyst precursor provided with the coating layer 1 by performing a first heat treatment process; and
a step of coating a solution containing a precursor of a perovskite-based compound represented by Chemical Formula 1 on the catalyst precursor provided with the coating layer 1, and then preparing a catalyst provided with a coating layer 2 by performing a second heat treatment process.

[Chemical Formula 1] $Sr_{1-x}A_xTi_{1-y}B_yO_{3-\delta}$

In Chemical Formula 1,

A is selected from Y, Sc, La and lanthanide series elements,
B is Cr, Mn, Fe, Co, Ni, Mo, Ru or Rh,
x is a real number which is 0 or greater and smaller than 1,
y is a real number which is 0 or greater and smaller than 1,
$\delta$ is a real number which is 0 or greater and smaller than 1, and
$(x + y) > 0$ is satisfied.

In addition, another embodiment of the present disclosure provides a catalyst for reforming methane, which comprises:

a porous metal support with the surface oxidized;
a coating layer 1 provided on the porous metal support with the surface oxidized and containing a first inorganic oxide; and
a coating layer 2 provided on the coating layer 1 and containing a perovskite-based compound represented by Chemical Formula 1, wherein
the coating layer 1 has a thickness of 5 nm to 100 nm, and
the thickness uniformity (%) of the coating layer 1 calculated by Equation 4 is 60% or higher.

(Minimum thickness of coating layer 1) / (maximum thickness of coating layer 1) x 100          [Equation 4]

[Advantageous Effects]

A catalyst for reforming methane according to an embodiment of the present disclosure, wherein a coating layer 1 containing a first inorganic oxide is formed, can not only improve adhesion between a porous metal support and a coating layer 2 containing a perovskite-based compound represented by Chemical Formula 1 but also prevent the side reaction of the porous metal support.

In addition, the catalyst for reforming methane according to an embodiment of the present disclosure, wherein the perovskite-based compound is supported on the porous metal support with high thermal conductivity, is advantageous in that the control of heat of reaction is easy as compared to the existing pellet-type or powder-type catalyst.

In addition, the catalyst for reforming methane according to an embodiment of the present disclosure is advantageous in that further increase in activity is possible due to the synergistic effect between the coating layer 1 containing the first inorganic oxide and the coating layer 2 containing the perovskite-based compound represented by Chemical Formula 1.

In addition, according to an embodiment of the present disclosure, since the coating layer 1 is formed by ALD, coating with a uniform thickness is possible without cracking, unlike the existing dip coating method. Accordingly, shielding effect can be achieved more clearly, and the elution/coating of the metal components of the support may be prevented during the coating of the catalyst component.

In addition, the catalyst for reforming methane according to an embodiment of the present disclosure is advantageous in that the elution of metals constituting the porous metal support may be prevented during the preparation of the catalyst for reforming methane since a film of the oxides of the metals constituting the porous metal support is formed on the surface of the porous metal support through oxidation.

[Brief Description of Drawings]

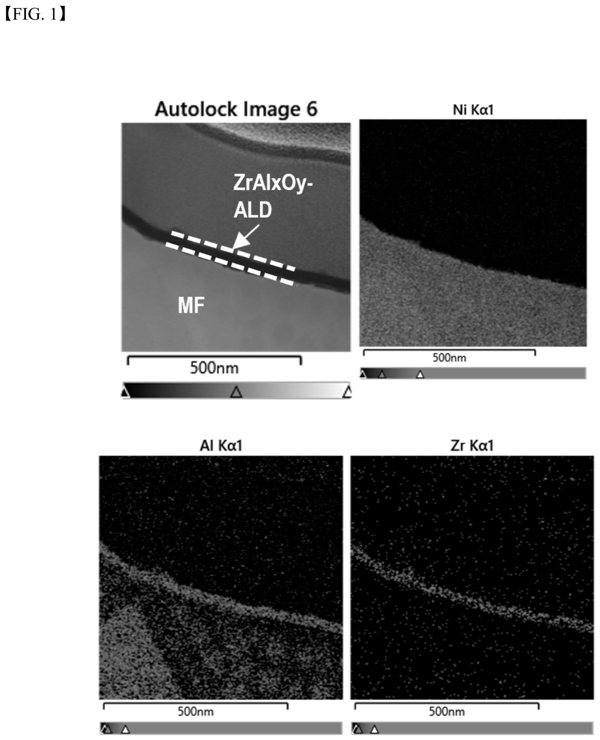

FIG. 1 shows the cross-sectional TEM (transmission electron microscopy) images of a catalyst for reforming methane prepared in Example 6 according to the present disclosure.

[Best Mode]

Hereinafter, the present disclosure will be described in more detail.
In the present specification, when a certain member is described to be located "on" another member, this comprises not only the case where the member is in contact with the another member but also the case where another member exists between the two members.

In the present specification, when a certain part is described to "comprise" a component, this does not exclude the presence of another component unless the context explicitly states otherwise but means that another component may be further comprised.

Currently, in the field of reformers, powder-type catalysts and pellet-type support catalysts are usually used in general. Although the powder-type catalysts may exhibit superior performance due to excellent dispersion degree of the catalyst, they are difficult to use directly in the industry. For example, when a reformer is driven using the powder-type catalyst, the catalyst is discharged together with a product after the reaction. In this case, the catalyst in the form of a powder accumulates gradually in the stream tube at the exit portion, and eventually, it may block the tube completely. Therefore, there is a disadvantage in that the powder-type catalysts cannot be used in the commercial reformers used in the industry.

In addition, the pellet-type support catalysts are currently frequently used in industrial reformers. Due to limited mass transfer rate, the performance of the catalyst deteriorates compared to the powder-type catalyst, but there is an advantage in that the pellet-type support catalyst can be used for a long period of time because a support is used. However, a $\gamma$-Al2O3 pellet, which is often used as the pellet-type support catalyst, has weak structural strength, and thus may be broken easily, and accordingly, there is a disadvantage in that a differential pressure may be generated in the reactor. Furthermore, since the volume of the pellet-type support catalyst is large, the volume becomes considerably large when the pellet-type support catalyst is used in a high-capacity reformer. Furthermore, although all reforming reactions are sensitive to reaction temperature, the existing pellet-type catalyst has a disadvantage in that heat is not distributed evenly throughout the reactor due to a large reduction in thermal conductivity. In addition, since the reforming reaction proceeds very fast, in the case of a pellet-type support, there is a disadvantage in that the utilization of the catalyst deteriorates with the effectiveness factor of the catalyst being 0.3 or lower.

During the dry reforming reaction of methane, coke generation decreases as the pressure in the reactor is lower. Therefore, a porous metal support is frequently used as a catalyst support to reduce pressure drop in the catalyst layer. However, the commercialization of the porous metal support has not been reported due to the side reaction of its metal components and coke generation.

Thus, the present disclosure is directed to providing a catalyst for reforming methane, which uses a porous metal support with high heat and mass transfer rates and can prevent the side reaction of the metal components of the porous metal support, coke generation, etc., and a method for preparing the same.

The method for preparing a catalyst for reforming methane according to an embodiment of the present disclosure comprises: a step of oxidizing the surface of a porous metal support; a step of forming a coating layer 1 containing a first inorganic oxide on the porous metal support with the surface oxidized by ALD (atomic layer deposition), and then preparing a catalyst precursor provided with the coating layer 1 by performing a first heat treatment process; and a step of coating a solution containing a precursor of a perovskite-based compound represented by Chemical Formula 1 on the catalyst precursor provided with the coating layer 1, and then preparing a catalyst provided with a coating layer 2 by performing a second heat treatment process.

$$[\text{Chemical Formula 1}] \qquad Sr_{1-x}A_xTi_{1-y}B_yO_{3-\delta}$$

In Chemical Formula 1,

A is selected from Y, Sc, La and lanthanide series elements,
B is Cr, Mn, Fe, Co, Ni, Mo, Ru or Rh,
x is a real number which is 0 or greater and smaller than 1,
y is a real number which is 0 or greater and smaller than 1,
$\delta$ is a real number which is 0 or greater and smaller than 1, and
(x + y) > 0 is satisfied.

In an embodiment of the present disclosure, the porous metal support may be a metal foam comprising NiCrAlFe, NiCrAl, SiC or $\alpha$-Al$_2$O$_3$.

The porous metal support is a support having various shapes. It has a small heat capacity and an excellent heat transfer lability, and can be molded into a desired shape for use. The form, size, etc. of the porous metal support are not particularly limited, and the porous metal support may have a porosity of 10% to 99%, 50% to 96%, or 85% to 96%. The pore size (cell size) of the porous metal support may be 400 $\mu$m to 1,500 $\mu$m, or 450 $\mu$m to 1,400 $\mu$m. If the pore size of the porous metal support is smaller than 400 $\mu$m, it may be difficult to coat the precursor solution. And, if it exceeds 1,500 $\mu$m, the surface area on which the catalyst can be coated is reduced, which may be disadvantageous in terms of the process. The porous metal support may be prepared appropriately by those skilled in the art using methods known in the art, in consideration of the material, pore size, porosity, etc. of the porous metal support.

The method for preparing a catalyst for reforming methane according to an embodiment of the present disclosure comprises a step of oxidizing the surface of the porous metal support.

The step of oxidizing the surface of the porous metal support may be performed by a process of oxidizing the porous metal support in the air at 800 °C to 1,200 °C for 2 hours or shorter, or at 900 °C to 1,150 °C for 1.5 hours or shorter, although not being limited thereto. When the porous metal support is a metal foam, if the temperature is below 800 °C, the surface of the metal foam cannot be oxidized and, if the temperature exceeds 1,200 °C or if the time exceeds 2 hours, it is undesirable because the cost of energy is excessive.

The method for preparing a catalyst for reforming methane according to an embodiment of the present disclosure comprises a step of forming a coating layer 1 containing a first inorganic oxide on the porous metal support with the surface oxidized by ALD (atomic layer deposition), and then preparing a catalyst precursor provided with the coating layer 1 by performing a first heat treatment process.

By using ALD (atomic layer deposition) for forming the coating layer 1 containing the first inorganic oxide on the porous metal support with the surface oxidized, the coating layer 1 may be formed on the porous metal support with a uniform thickness without cracks and, therefore, the elution of the metal components of the porous metal support may be prevented.

The ALD is a technique of depositing ultra-thin films of an atomic layer thickness level while exposing a precursor and a reactant, which are raw materials of the thin film, to the surface of a substrate in vacuum state. Materials known in the art may be used as the precursor, reactant, etc.

The precursor refers to a precursor of the inorganic material that constitutes the first inorganic oxide. More specifically, it may be $Al(CH_3)_3$, $Al(CH_3)_2Cl$, $AlCl_3$, $Al(C_2H_5)_3$, zirconium tert-butoxide (ZTB), tetrakis(diethylamino) zirconium (TDEAZ), tetrakis(ethylmethylamino)zirconium (TEMAZ), tetrakis(dimethylamino)zirconium (TDMAZ), etc., although not being limited thereto.

The reactant may be $H_2O$, $H_2O_2$, $O_2$, $O_3$, NO, CO, $CO_2$, $CH_3OH$, $C_2H_5OH$, $N_2O$, a mixture gas thereof, etc., although not being limited thereto.

A purge gas may be used during the ALD process. The purge gas may be an inert gas such as Ar, Ne and He, $N_2$, $H_2$, etc., although not being limited thereto.

The condition, equipment, etc. of the ALD process will be described more specifically in the examples described below.

In an embodiment of the present disclosure, before forming the coating layer 1 containing the first inorganic oxide, a step of forming a coating layer 1-1 containing a second inorganic oxide on the porous metal support with the surface oxidized by dip coating may be further comprised. In this case, the coating layer 1 containing the first inorganic oxide may be formed on the coating layer 1-1 containing the second inorganic oxide. The step of forming the coating layer 1-1 containing the second inorganic oxide may comprise: a step of coating a solution containing a precursor of the second inorganic oxide on the porous metal support with the surface oxidized by dip coating; and a step of performing a third heat treatment process. As such, if the coating layer 1 containing the first inorganic oxide is formed by ALD after the coating layer 1-1 containing the second inorganic oxide is formed by dip coating, shielding effect can be achieved effectively even with relatively few ALD cycles.

In an embodiment of the present disclosure, after the coating layer 1 has been formed, a step of forming a coating layer 1-1 containing a second inorganic oxide by dip coating may be further comprised. In this case, the coating layer 2 may be formed on the coating layer 1-1. The step of forming the coating layer 1-1 containing the second inorganic oxide by dip coating may be performed by dip-coating a solution containing a precursor of the second inorganic oxide.

Accordingly, an inorganic oxide layer formed on the porous metal support with the surface oxidized may comprise only the coating layer 1 of the first inorganic oxide formed by ALD, or may comprise the coating layer 1 of the first inorganic oxide formed by ALD and the coating layer 1-1 of the second inorganic oxide formed by dip coating. More specifically, the catalyst for reforming methane according to an embodiment of the present disclosure may have the following structures.

- Porous metal support with the surface oxidized / coating layer 1 (ALD, first inorganic oxide) / coating layer 2 (perovskite-based compound of Chemical Formula 1)
- Porous metal support with the surface oxidized / coating layer 1-1 (dip coating, second inorganic oxide) / coating layer 1 (ALD, first inorganic oxide) / coating layer 2 (perovskite-based compound of Chemical Formula 1)
- Porous metal support with the surface oxidized / coating layer 1 (ALD, first inorganic oxide) / coating layer 1-1 (dip coating, second inorganic oxide) / coating layer 2 (perovskite-based compound of Chemical Formula 1)

In an embodiment of the present disclosure, the coating layer 1 and the coating layer 1-1 may contain the same inorganic oxide, or may contain different inorganic oxides. More specifically, each of the coating layer 1 and the coating layer 1-1 may independently contain an inorganic oxide comprising one or more of Al, Ce, Zr, Y, Ti and Si. In addition, each of the coating layer 1 and the coating layer 1-1 may independently contain one or more selected from $AlO_x$ ($0 < x \leq 1.6$),

$Al_2O_3$ and $ZrO_2$.

In addition, each of the coating layer 1 and the coating layer 1-1 may independently contain $ZrAl_xO_y$ ($1 < x < 3, 3 < y < 9$). In particular, the $ZrAl_xO_y$ ($1 < x < 3, 3 < y < 9$) is advantageous in that the surface of the porous metal support can be stabilized more as compared to single inorganic oxides such as $ZrO_2$, $Al_2O_3$, etc. since the grain size is smaller, it is packed more densely and the density of the $ZrAl_xO_y$ ($1 < x < 3, 3 < y < 9$) is increased as compared to that of the mixture of $ZrO_2$ and $Al_2O_3$.

The solution containing the precursor of the second inorganic oxide may be provided not only as a dispersion of the second inorganic oxide but also as a sol, gel or solution containing the precursor of the second inorganic oxide. As a solvent of the solution containing the precursor of the second inorganic oxide, not only water but also a solvent known in the art may be used, although not being specially limited thereto.

The precursor of the second inorganic oxide is not specially limited, and an ammonium salt, nitrate, carbonate, chloride, sulfate, hydroxide, organic acid salt, oxide or a mixture thereof may be used.

The method for preparing a catalyst for reforming methane according to an embodiment of the present disclosure comprises a step of coating a solution containing a precursor of a perovskite-based compound represented by Chemical Formula 1 on the catalyst precursor provided with the coating layer 1, and then preparing a catalyst provided with a coating layer 2 by performing a second heat treatment process.

In an embodiment of the present disclosure, the solution containing the precursor of the perovskite-based compound represented by Chemical Formula 1 may be in the form of a sol or a gel.

The precursor of the perovskite-based compound is a precursor of a metal constituting a perovskite-based compound, and its content may be controlled to control the molar ratio of metals of the perovskite-based compound. In addition, the precursor of the metal is not specially limited, and an ammonium salt, nitrate, carbonate, chloride, sulfate, hydroxide, organic acid salt, oxide or a mixture thereof of the metal element may be used.

In an embodiment of the present disclosure, Chemical Formula 1 may be represented by Chemical Formula 2 or 3, although not being limited thereto.

[Chemical Formula 2] $\quad\quad SrTi_{1-y}B_yO_{3-\delta}$

[Chemical Formula 3] $\quad\quad Sr_{1-x}Y_xTi_{1-y}B_yO_{3-\delta}$

In Chemical Formulas 2 and 3,

B is Ni or Rh,
x is a real number which is 0 or greater and smaller than 1,
y is a real number which is 0 or greater and smaller than 1, and
$\delta$ is a real number which is 0 or greater and smaller than 1.

In an embodiment of the present disclosure, the coating the solution containing the precursor of the perovskite-based compound represented by Chemical Formula 1 on the catalyst precursor provided with the coating layer 1 may be performed by methods known in the art, e.g., dip coating, wash coating, etc., although not being limited thereto.

In an embodiment of the present disclosure, each of the first to third heat treatment processes may independently comprise a drying step and a sintering step. The drying may be performed at 50 °C to 150 °C for 1 hour to 48 hours, or at 60 °C to 100 °C for 5 hours to 36 hours, although not being limited thereto. In addition, the sintering may be performed under air atmosphere at 350 °C to 1,100 °C for 1 hour to 10 hours, or under air atmosphere at 500 °C to 1,000 °C for 1.5 hours to 8 hours, although not being limited thereto. If the temperature of the sintering step is below 350 °C, a perovskite phase may not be formed properly. And, if it exceeds 1,100 °C, the durability of the porous metal support may deteriorate undesirably.

In an embodiment of the present disclosure, after the second heat treatment process, a step of measuring the weight of the coating layer 2 supported on the porous metal support may be comprised. In addition, after coating the second solution until a desired amount of the catalyst is supported on the porous metal support by measuring the weight of the coating layer 2 supported on the porous metal support, the step of performing the second heat treatment process may be repeated 2 to 10 times.

In addition, another embodiment of the present disclosure provides a catalyst for reforming methane, which is prepared by the method for preparing a catalyst for reforming methane.

In addition, another embodiment of the present disclosure provides a catalyst for reforming methane, which comprises a porous metal support with the surface oxidized; a coating layer 1, which is provided on the porous metal support with the surface oxidized and contains a first inorganic oxide; and a coating layer 2, which is provided on the coating layer 1 and contains a perovskite-based compound represented by Chemical Formula 1.

In an embodiment of the present disclosure, the coating layer 1 of the catalyst for reforming methane has a thickness of 5 nm to 100 nm, and has a thickness uniformity (%) calculated by Equation 4 of 60% or higher.

(Minimum thickness of coating layer 1) / (maximum thickness of coating layer 1) x 100       [Equation 4]

In an embodiment of the present disclosure, the coating layer 1 may have a thickness of 5 nm to 100 nm, 10 nm to 80 nm, 20 nm to 50 nm, or 50 nm to 70 nm. If the thickness of the coating layer 1 exceeds 100 nm, it may be difficult to form the coating layer 2 containing the perovskite-based compound represented by Chemical Formula 1 and, accordingly, the activity of the catalyst may be reduced undesirably compared to the volume of the porous metal support. And, if the thickness of the coating layer 1 is smaller than 5 nm, it may be difficult to achieve the effect of the coating layer 1.

In an embodiment of the present disclosure, the coating layer 1 may have a thickness uniformity (%) calculated by Equation 4 of 60% or higher, 65% or higher, or 70% or higher, and 100% or lower. If the thickness uniformity (%) of the coating layer 1 is lower than 60%, it may be difficult to achieve a uniform shielding effect by the coating layer 1 due to large variation in thickness and, accordingly, the metal components of the support may be eluted undesirably during the coating of catalyst components.

The thickness of the coating layer 1 may be measured using methods known in the art. For example, the thickness of the coating layer 1 may be measured from the cross-sectional image of the catalyst obtained by TEM (transmission electron microscopy), SEM (scanning electron microscopy), etc., although not being limited thereto. The cross-section of the catalyst is a plane comprising the thickness direction of the catalyst, i.e., the direction wherein the porous metal support, the coating layer 1 and the coating layer 2 are stacked. More specifically, the thickness of the coating layer 1 may be measured based on the cross-sectional profile from the TEM or SEM image of a thin film sample comprising the stacking direction of the porous metal support, the coating layer 1 and the coating layer 2 using a FIB (focused ion beam). From the cross-sectional profile from the TEM or SEM image, the maximum thickness and minimum thickness of the coating layer 1 may be measured. When measuring the maximum thickness and minimum thickness of the coating layer 1, the thickness at both ends of the cross-sectional profile corresponding to the coating layer 1 may be excluded.

In addition, a coating layer 1-1 containing a second inorganic oxide may be further comprised between the porous metal support with the surface oxidized and the coating layer 1. In addition, a coating layer 1-1 containing a second inorganic oxide may be further comprised between the coating layer 1 and the coating layer 2.

In an embodiment of the present disclosure, the coating layer 1 may consist only of the first inorganic oxide, the coating layer 1-1 may consist only of the second inorganic oxide, and the coating layer 2 may consist only of the perovskite-based compound represented by Chemical Formula 1.

In an embodiment of the present disclosure, the total content of the coating layer 1 and coating layer 1-1 containing the first inorganic oxide and second inorganic oxide may be 1 wt% to 15 wt%, or 2 wt% to 13 wt%, based on the total weight of the porous metal support. If the total content of the coating layer 1 and coating layer 1-1 exceeds 15 wt%, it may be difficult to form the coating layer 2 containing the perovskite-based compound represented by Chemical Formula 1 and, accordingly, the activity of the catalyst may be reduced undesirably compared to the volume of the porous metal support. And, if the total content of the coating layer 1 and coating layer 1-1 is below 1 wt%, it may be difficult to achieve the effect of the coating layers containing the inorganic oxides.

In an embodiment of the present disclosure, the weight ratio of the coating layer 1 and the coating layer 1-1 : the coating layer 2 may be 1 : 5 to 1 : 20, or 1 : 7 to 1 : 15. If the weight ratio is outside the above ranges, the activity of the catalyst may be reduced undesirably compared to the volume of the porous metal support.

In an embodiment of the present disclosure, the content of the coating layer 2 containing the perovskite-based compound represented by Chemical Formula 1 may be 3 wt% to 40 wt%, 6 wt% to 35 wt%, or 7 wt% to 30 wt%, based on the total weight of the catalyst for reforming methane. If the content of the coating layer 2 containing the perovskite-based compound represented by Chemical Formula 1 is below 3 wt% based on the total weight of the catalyst for reforming methane, reactivity may be reduced undesirably because of relatively fewer active sites on the surface of the catalyst. And, if the content of the coating layer 2 containing the perovskite-based compound represented by Chemical Formula 1 exceeds 40 wt%, it may be difficult to maintain pore structure and bond the catalyst components to the porous metal support because of a relatively large amount of the catalyst components compared to the porous metal support and, accordingly, the practical benefits of the reforming reaction may be reduced.

In an embodiment of the present disclosure, the coating layer 1 and the coating layer 1-1 may be provided on the entire surface of the porous metal support.

In an embodiment of the present disclosure, the coating layer 1 containing the first inorganic oxide may serve to fix the coating layer 2 containing the perovskite-based compound represented by Chemical Formula 1 on the porous metal support. In addition, the coating layer 2 containing the perovskite-based compound represented by Chemical Formula 1 may be in the form of protrusions on the coating layer 1 and, accordingly, the performance of the methane reforming reaction may be improved due to increased surface area of the catalyst.

In addition, according to an embodiment of the present disclosure, by simultaneously applying the coating layer 1 containing the first inorganic oxide and the coating layer 2 containing the perovskite-based compound represented by Chemical Formula 1, the total content of the catalyst supported on the porous metal support may be increased compared to when catalyst particles are applied alone. In addition, according to an embodiment of the present disclosure, the durability and performance of the catalyst can be improved because it is possible to prevent a phenomenon in which metals (Ni, Cr, etc.) which are the main components of the porous metal support are exposed to the surface as metal oxides (NiO, $Cr_2O_3$, etc.) under the long-term operation condition at high temperature (750 °C or higher) and prevent the change in the proportion of the components or phase of the catalyst by applying the coating layer 1 containing the first inorganic oxide.

In an embodiment of the present disclosure, the catalyst for reforming methane may be applied to a steam reforming process, a carbon dioxide ($CO_2$) reforming process, a catalytic partial oxidation process, an autothermal reforming process, a tri-reforming process or a mixed reforming process, and the methane reforming process is not particularly limited.

The catalyst for reforming methane according to an embodiment of the present disclosure, wherein the coating layer 1 containing the first inorganic oxide is formed, can not only improve adhesion between the porous metal support and the coating layer 2 containing the perovskite-based compound represented by Chemical Formula 1 but also prevent the side reaction of the porous metal support.

In addition, the catalyst for reforming methane according to an embodiment of the present disclosure, wherein the perovskite-based compound is supported on the porous metal support with high thermal conductivity, is advantageous in that the control of heat of reaction is easy as compared to the existing pellet-type or powder-type catalyst.

In addition, the catalyst for reforming methane according to an embodiment of the present disclosure is advantageous in that further increase in activity is possible due to the synergistic effect between the coating layer 1 containing the first inorganic oxide and the coating layer 2 containing the perovskite-based compound represented by Chemical Formula 1.

In addition, according to an embodiment of the present disclosure, since the coating layer 1 is formed by ALD, coating with a uniform thickness is possible without cracking, unlike the existing dip coating method. Accordingly, shielding effect can be achieved more clearly, and the elution/coating of the metal components of the support may be prevented during the coating of the catalyst component.

In addition, the catalyst for reforming methane according to an embodiment of the present disclosure is advantageous in that the elution of metals constituting the porous metal support may be prevented during the preparation of the catalyst for reforming methane since a film of the oxides of the metals constituting the porous metal support is formed on the surface of the porous metal support through oxidation. In particular, the catalyst for reforming methane according to an embodiment of the present disclosure can further prevent the exposure of the components such as NiO, $CrO_x$, etc. from the oxide film because the coating layer 1 containing the first inorganic oxide is further formed on the metal oxide film constituting the porous metal support by ALD (atomic layer deposition).

[Mode for Invention]

Hereinafter, the present disclosure will be described specifically through examples. However, the examples of the present disclosure may be varied into various other forms, and the scope of the present disclosure should not be construed as being limited to the examples described below. The examples of the present disclosure are provided to more completely explain the present disclosure to those having ordinary knowledge in the art.

**<Examples>**

**<Example 1>**

**1) Oxidation of porous metal support**

A porous metal support (NiCrAl, average pore size: 1,200 $\mu$m) was oxidized by heat-treating under air atmosphere at 1,000 °C for 1 hour.

**2) Formation of coating layer 1**

A coating layer 1 containing a first inorganic oxide ($AlO_x$, $0 < x \leq 1.6$) was formed on the porous metal support with the surface oxidized by ALD as described below to a thickness of about 25 nm. Then, a catalyst precursor provided with the coating layer 1 was prepared by heat-treating under air atmosphere at 900 °C for 5 hours.

<ALD process>

1. 6 g of the porous metal support with the surface oxidized loaded in an ALD chamber (CN1)
2. TMA (trimethylaluminum, EG Chem) canister temperature 25 °C, $H_2O$ (EG Chem) canister temperature 25 °C
3. Pressure 1.6 Torr, Ar carrier gas flow 300 sccm, chamber temperature 150 °C
4. ALD:

$$[(TMA\ pulse\ 3\ s\ /\ purge\ 120\ s\ -\ H_2O\ pulse\ 3\ s\ /\ purge\ 120\ s)]\ x\ 200\ cycles$$

### 3) Formation of coating layer 2

A solution containing a precursor of a perovskite compound ($Sr_{0.9}Y_{0.1}Ti_{0.93}Ni_{0.07}O_{3-\delta}$, $0 < \delta < 1$) was prepared by a citrate method. Strontium nitrate ($Sr(NO_3)_3 \cdot H_2O$), yttrium nitrate ($Y(NO_3)_3$) and nickel nitrate ($Ni(NO_3)_2$) were dissolved in distilled water together with citric acid. After dissolving titanium isopropoxide ($Ti(OCH(CH_3)_2)_4$) in ethylene glycol, the two solutions were mixed at 70 °C. Then, the mixed solution was stirred for 3 hours and stored after cooling to room temperature. The concentration of the solution was 0.1 M, and the molar ratio of strontium : yttrium : titanium : nickel was 0.9 : 0.1 : 0.93 : 0.07.

After dip-coating the solution containing the catalyst precursor on the catalyst precursor provided with the coating layer 1, heat treatment was performed under air atmosphere at 900 °C for 5 hours after drying at 150 °C for 5 hours. Finally, a catalyst provided with the coating layer 1 ($AlO_x$, $0 < x \leq 1.6$) and the coating layer 2 ($Sr_{0.9}Y_{0.1}Ti_{0.93}Ni_{0.07}O_{3-\delta}$, $0 < \delta < 1$) on the porous metal support with the surface oxidized was prepared by repeating the dip coating of the solution containing the catalyst precursor, drying and heat treatment several times. The content of the perovskite-based compound represented by Chemical Formula 1 ($Sr_{0.9}Y_{0.1}Ti_{0.93}Ni_{0.07}O_{3-\delta}$, $0 < \delta < 1$) was 20 wt% based on the catalyst for reforming methane.

The content of the perovskite-based compound represented by Chemical Formula 1 can be calculated by Equation 1.

Content of perovskite-based compound represented by Chemical Formula 1 (wt%) = (total weight of catalyst - total weight after formation of coating layer 1) / (total weight of catalyst) x 100          [Equation 1]

### <Example 2>

A catalyst was prepared in the same manner as in Example 1, except that the ALD process was performed for 400 cycles instead of 200 cycles during the formation of the coating layer 1. The thickness of the coating layer 1 was about 50 nm.

### <Example 3>

A catalyst was prepared in the same manner as in Example 1, except that a coating layer 1 containing a first inorganic oxide ($ZrO_2$), instead of the coating layer 1 containing $AlO_x$, was formed to a thickness of about 50 nm by ALD as described below.

<ALD process>

1. 6 g of the porous metal support with the surface oxidized loaded in an ALD chamber (CN1)
2. TEMAZ (tetrakis(ethylmethylamino)zirconium, EG Chem) canister temperature 80 °C, $H_2O$ (EG Chem) canister temperature 25 °C
3. Pressure 1.6 Torr, Ar carrier gas flow 300 sccm, chamber temperature 150 °C
4. ALD:

$$[(TEMAZ\ pulse\ 20\ s\ /\ purge\ 600\ s\ -\ H_2O\ pulse\ 3\ s\ /\ purge\ 300\ s)]\ x\ 250\ cycles$$

### <Example 4>

A porous metal support was oxidized in the same manner as in Example 1.
An aqueous solution containing 25 wt% of $Al(NO_3)_3 \cdot 9H_2O$ was prepared as a solution containing a precursor of a second inorganic oxide. After forming a coating layer 1-1 containing the second inorganic oxide by dip-coating the solution containing the precursor of the second inorganic oxide on the porous metal support with the surface oxidized, heat treatment was performed under air atmosphere at 900 °C for 5 hours after drying at 150 °C for 5 hours. The dip coating of the solution containing the precursor of the second inorganic oxide, drying and heat treatment were performed once or several times.

A coating layer 1 containing a first inorganic oxide ($AlO_x$, $0 < x \leq 1.6$) was formed by ALD on the porous metal support with the coating layer 1-1 formed. During the formation of the coating layer 1, the ALD process was performed in the same manner as in Example 1, except that it was performed for 48 cycles instead of 200 cycles. The thickness of the coating layer 1 was about 6 nm.

Finally, a catalyst provided with coating layer 1-1 ($AlO_x$, $0 < x \leq 1.6$), the coating layer 1 ($AlO_x$, $0 < x \leq 1.6$) and a coating layer 2 ($Sr_{0.9}Y_{0.1}Ti_{0.93}Ni_{0.07}O_{3-\delta}$, $0 < \delta < 1$) on the porous metal support with the surface oxidized was prepared by forming a coating layer 2 on the porous metal support with the coating layer 1-1 and the coating layer 1 formed in the same manner as in Example 1. The content of the coating layer 1-1 was 5 wt% based on the catalyst for reforming methane, and the content of the perovskite-based compound represented by Chemical Formula 1 ($Sr_{0.9}Y_{0.1}Ti_{0.93}Ni_{0.07}O_{3-\delta}$, $0 < \delta < 1$) was 20 wt%.

The content of the coating layer 1-1 and the content of the perovskite-based compound represented by Chemical Formula 1 can be calculated by Equation 2 and Equation 3, respectively.

Content of coating layer 1-1 (wt%) = (total weight after formation of coating layer 1-1 - total weight before formation of coating layer 1-1) / (total weight of catalyst) x 100    [Equation 2]

Content of perovskite-based compound represented by Chemical Formula 1 (wt%) = (total weight of catalyst - total weight after formation of coating layer 1-1 and coating layer 1) / (total weight of catalyst) x 100    [Equation 3]

**<Example 5>**

A catalyst was prepared in the same manner as in Example 4, except that a coating layer 1-1 containing a second inorganic oxide ($ZrO_2$) was formed using $ZrO(NO_3)_2 \cdot xH_2O$ (30 wt%) instead of $Al(NO_3)_3 \cdot 9H_2O$ during the preparation of the solution containing the precursor of the second inorganic oxide.

**<Example 6>**

**1) Oxidation of porous metal support**

A porous metal support (NiCrAl, average pore size: 1,200 $\mu$m) was oxidized by heat-treating under air atmosphere at 1,000 °C for 1 hour.

**2) Formation of coating layer 1**

A coating layer 1 containing $ZrAl_xO_y$ ($1 < x < 3$, $3 < y < 9$) was formed on the porous metal support with the surface oxidized by ALD to a thickness of about 25 nm. Then, a catalyst precursor provided with the coating layer 1 was prepared by heat-treating under air atmosphere at 900 °C for 5 hours.

<ALD process>

1. 6 g of the porous metal support with the surface oxidized loaded in an ALD chamber (CN1)
2. TEMAZ (tetrakis(ethylmethylamino)zirconium, EG Chem) canister temperature 80 °C, TMA (trimethylaluminum, EG Chem) canister temperature 25 °C, $H_2O$ (EG Chem) canister temperature 25 °C
3. Pressure 1.6 Torr, Ar carrier gas flow 300 sccm, chamber temperature 150 °C
4. ALD:

[(TMA pulse 3 s / purge 120 s - $H_2O$ pulse 3 s / purge 120 s) - (TEMAZ pulse 20 s / purge 600 s - $H_2O$ pulse 3 s / purge 300 s)] x 114 cycles

**3) Formation of coating layer 2**

A solution containing a precursor of a perovskite compound ($SrTi_{0.93}Ni_{0.07}O_{3-\delta}$, $0 < \delta < 1$) was prepared by a citrate method. Strontium nitrate ($Sr(NO_3)_3 \cdot H_2O$), nickel nitrate ($Ni(NO_3)_2$), citric acid and ethylene glycol were dissolved in distilled water. After dissolving titanium isopropoxide ($Ti(OCH(CH_3)_2)_4$) in ethanol, the two solutions were mixed at 70 °C. Then, the mixed solution was stirred for 3 hours and stored after cooling to room temperature. The concentration of the solution was 0.1 M, and the molar ratio of strontium : titanium : nickel was 1 : 0.97 : 0.03.

After dip-coating the solution containing the catalyst precursor on the catalyst precursor provided with the coating layer 1, heat treatment was performed under air atmosphere at 900 °C for 5 hours after drying at 150 °C for 5 hours. Finally, a catalyst provided with the coating layer 1 ($ZrAl_xO_y$, $1 < x < 3$, $3 < y < 9$) and the coating layer 2 ($SrTi_{0.93}Ni_{0.07}O_{3-\delta}$, $0 < \delta < 1$) on the porous metal support with the surface oxidized was prepared by repeating the dip coating of the solution containing the catalyst precursor, drying and heat treatment several times. The content of the perovskite-based compound represented by Chemical Formula 1 ($SrTi_{0.93}Ni_{0.07}O_{3-\delta}$, $0 < \delta < 1$) was 15 wt% based on the catalyst for reforming methane.

The cross-sectional TEM (transmission electron microscopy) images of the catalyst for reforming methane prepared in Example 6 is shown in FIG. 1.

**<Example 7>**

A catalyst was prepared in the same manner as in Example 1, except that ruthenium chloride ($RuCl_3$) was used instead of nickel nitrate, and the precursor was used such that the molar ratio of strontium : titanium : ruthenium was 1 : 0.93 : 0.07 when preparing a solution containing the precursor of the coating layer 2.

**<Comparative Example 1>**

A catalyst was prepared in the same manner as in Example 1, except that the coating layer 2 was formed without forming the coating layer 1.

**<Comparative Example 2>**

A catalyst was prepared in the same manner as in Example 1, except that the coating layer 1 and the coating layer 2 were formed without oxidizing the porous metal support.

**<Comparative Example 3>**

A catalyst was prepared in the same manner as in Example 3, except that the coating layer 1-1 was formed by dip-coating a solution containing a precursor of an inorganic oxide ($ZrO(NO_3)_2 \cdot xH_2O$ (20 wt%)) instead of forming the coating layer 1 by ALD.

**<Comparative Example 4>**

A catalyst was prepared in the same manner as in Example 4, except that the coating layer 1-1 and the coating layer 2 were formed without the coating layer 1.

**<Comparative Example 5>**

A catalyst was prepared in the same manner as in Example 6, except that the coating layer 2 was formed without forming the coating layer 1.

**<Comparative Example 6>**

A catalyst was prepared in the same manner as in Example 1, except that the coating layer 2 was not formed.

[Table 1]

| | Surface oxidation of porous metal support | Coating layer 1-1 (dip coating) | Coating layer 1 (ALD) | Coating layer 2 |
|---|---|---|---|---|
| Example 1 | O | - | $AlO_x$ | $Sr_{0.9}Y_{0.1}Ti_{0.93}Ni_{0.07}O_{3-\delta}$ |

(continued)

| | Surface oxidation of porous metal support | Coating layer 1-1 (dip coating) | Coating layer 1 (ALD) | Coating layer 2 |
|---|---|---|---|---|
| Example 2 | O | - | $AlO_x$ | $Sr_{0.9}Y_{0.1}Ti_{0.93}Ni_{0.07}O_{3-\delta}$ |
| Example 3 | O | - | $ZrO_2$ | $Sr_{0.9}Y_{0.1}Ti_{0.93}Ni_{0.07}O_{3-\delta}$ |
| Example 4 | O | $AlO_x$ | $AlO_x$ | $Sr_{0.9}Y_{0.1}Ti_{0.93}Ni_{0.07}O_{3-\delta}$ |
| Example 5 | O | $ZrO_2$ | $AlO_x$ | $Sr_{0.9}Y_{0.1}Ti_{0.93}Ni_{0.07}O_{3-\delta}$ |
| Example 6 | O | - | $ZrAl_xO_y$ | $SrTi_{0.93}Ni_{0.07}O_{3-\delta}$ |
| Example 7 | O | - | $AlO_x$ | $SrTi_{0.93}Ru_{0.07}O_{3-\delta}$ |
| Comparative Example 1 | O | - | - | $Sr_{0.9}Y_{0.1}Ti_{0.93}Ni_{0.07}O_{3-\delta}$ |
| Comparative Example 2 | X | - | $AlO_x$ | $Sr_{0.9}Y_{0.1}Ti_{0.93}Ni_{0.07}O_{3-\delta}$ |
| Comparative Example 3 | O | $ZrO_2$ | - | $Sr_{0.9}Y_{0.1}Ti_{0.93}Ni_{0.07}O_{3-\delta}$ |
| Comparative Example 4 | O | $AlO_x$ | - | $Sr_{0.9}Y_{0.1}Ti_{0.93}Ni_{0.07}O_{3-\delta}$ |
| Comparative Example 5 | O | - | - | $SrTi_{0.93}Ni_{0.07}O_{3-\delta}$ |
| Comparative Example 6 | O | - | $AlO_x$ | - |

**<Experimental Example 1> Evaluation of dry reforming reaction of methane**

A fixed-bed reaction system was used to perform dry reforming reaction of methane. Each of the catalysts of the examples and comparative examples (about 2 g) was packed in a quartz tube reactor (inner diameter = 1/2 inch, length = 50 cm). First, after reducing the catalyst under 10% $H_2/N_2$ condition at 800 °C for 2 hours, catalytic reaction was performed for 24 hours. In order to more clearly compare the difference in coke generation between the catalysts, the activity characteristics of the catalysts were evaluated under pressurized conditions.

Gas composition: $CH_4$ : $CO_2$ : He = 1 : 1.12 : 0.3
Flow rate: GHSV (gas hour space velocity) = 1,640 $hr^{-1}$ (based on $CH_4$)
Reaction temperature: 800 °C
Reaction pressure: 5 barg

Conversion rate was calculated after 24 hours of the reaction by analyzing the composition of the produced gas by gas chromatography (GC), and the result is shown in Table 2.

$$\text{Conversion rate } (Xi, \%) = [(Fi_{in} - Fi_{out}) / Fi_{in}] \times 100 \ (Fi = \text{flow rate of } i)$$

Coke generation amount (wt%) = (weight of produced C / total weight of catalyst before reaction) x 100

The coke generation amount (wt%) was calculated by dividing the weight of produced C obtained through a temperature-programmed oxidation analysis of the catalyst after the reaction by the total weight of the catalyst before the reaction. The temperature-programmed oxidation analysis was performed under 5% $O_2$/He condition while increasing temperature to 800 °C at a rate of 10 °C/min.

**<GC analysis condition>**

1) GC model: Agilent 6890
2) Oven temp.: 40 °C/7 min - 90 °C/5 min - 180 °C/6 min
3) Detector: TCD, 250 °C
4) Sample loop: 0.25 mL
5) Valve box temp.: 150 °C

[Table 2]

| Catalyst | $CH_4$ conversion rate (%) | $CO_2$ conversion rate (%) | Coke generation amount (wt%) |
|---|---|---|---|
| Example 1 | 67 | 71 | 2.5 |
| Example 2 | 67 | 71 | 2.15 |
| Example 3 | 68 | 72 | 1.96 |
| Example 4 | 66 | 70 | 1.82 |
| Example 5 | 69 | 70 | 1.58 |
| Example 7 | 67 | 73 | 1.01 |
| Comparative Example 1 | 58 | 68 | 9.85 |
| Comparative Example 2 | 41 | 59 | 7.67 |
| Comparative Example 3 | 65 | 70 | 5.71 |
| Comparative Example 4 | 63 | 72 | 8.3 |
| Comparative Example 6 | 54 | 62 | 10.19 |

**<Experimental Example 2> Evaluation of dry reforming reaction of methane**

A fixed-bed reaction system was used to perform dry reforming reaction of methane. Each of the catalysts of the examples and comparative examples (about 2 g) was packed in a quartz tube reactor (inner diameter = 1/2 inch, length = 50 cm). First, after reducing the catalyst under 10% $H_2/N_2$ condition at 800 °C for 2 hours, catalytic reaction was performed for 24 hours. In order to more clearly compare the difference in coke generation between the catalysts, the activity characteristics of the catalysts were evaluated under pressurized conditions.

Gas composition: $CH_4$ : $CO_2$ : He = 1 : 1.12 : 0.3
Flow rate: GHSV (gas hour space velocity) = 1,640 $hr^{-1}$ (based on $CH_4$)
Reaction temperature: 800 °C
Reaction pressure: 5 barg

Conversion rate was calculated after 24 hours of the reaction by analyzing the composition of the produced gas by gas chromatography (GC), and the result is shown in Table 3.

$$\text{Conversion rate } (Xi, \%) = [(Fi_{in} - Fi_{out}) / Fi_{in}] \times 100 \ (Fi = \text{flow rate of i})$$

$$\text{Coke generation amount (mol\%)} = (\text{mol of produced C} / \text{mol of } CH_4 \text{ reacted}) \times 100$$

**<GC analysis condition>**

1) GC model: Agilent 6890
2) Oven temp.: 40 °C/7 min - 90 °C/5 min - 180 °C/6 min
3) Detector: TCD (thermal conductivity detector), 250 °C
4) Sample loop: 0.25 mL
5) Valve box temp.: 150 °C

[Table 3]

| Catalyst | $CH_4$ conversion rate (%) | Coke generation amount (mol%) |
|---|---|---|
| Example 6 | 60 | 0.0008 |

(continued)

| Catalyst | CH$_4$ conversion rate (%) | Coke generation amount (mol%) |
|---|---|---|
| Comparative Example 5 | 57 | 0.0131 |

From Tables 2 and 3, it can be seen that the catalysts for reforming methane of the examples according to an embodiment of the present disclosure exhibit high CH$_4$ conversion rate and significantly low coke generation amount as compared to those of the comparative examples. It can be seen that the catalysts for reforming methane of the examples according to an embodiment of the present disclosure, which comprise the oxidized porous metal support, the coating layer 1 formed by ALD, and the coating layer 2 containing the perovskite-based compound represented by Chemical Formula 1, show reduced side reactions originating from the porous metal support and the coating layer 2 containing the perovskite-based compound.

**<Experimental Example 3> Evaluation of thickness uniformity (%) of coating layer 1 of catalyst**

The thickness uniformity (%) of the coating layer 1 of the catalysts for reforming methane prepared in Example 3 and Comparative Example 3 was evaluated, and the result is shown in Table 4. The thickness uniformity (%) of the coating layer 1 of the catalyst was evaluated as follows. After preparing a thin film sample comprising the stacking direction of the porous metal support, the coating layer 1 and the coating layer 2 of the catalyst for reforming methane using a FIB (focused ion beam), the maximum thickness and minimum thickness of the coating layer 1 were measured based on the cross-sectional profile from the TEM (transmission electron microscopy) image, and the thickness uniformity (%) was calculated by Equation 4. For the TEM image analysis, Talos F200X (FETEM, Thermo Fisher) was used and an accelerating voltage of 200 kV was applied.

$$\text{(minimum thickness of coating layer 1) / (maximum thickness of coating layer 1) x 100} \qquad \text{[Equation 4]}$$

[Table 4]

| | Coating layer 1 | | |
|---|---|---|---|
| | Maximum thickness (nm) | Minimum thickness (nm) | Thickness uniformity (%) |
| Example 3 | 70 | 50 | 71.4 |
| Comparative Example 3 | 69 | 23 | 33.3 |

As seen from Table 4, it was confirmed that, whereas the coating layer 1 of the catalyst for reforming methane of Example 3 exhibited uniform thickness, with the coating layer 1 being formed on the support with a thickness uniformity (%) of 71.4%, the coating layer 1 of the catalyst for reforming methane of Comparative Example 3 showed significant variation in the thickness of the coating layer 1, with a thickness uniformity (%) of 33.3%. In addition, it was confirmed that the coating layer 1 was not formed in some region of the catalyst for reforming methane of Comparative Example 3.

Accordingly, the catalyst for reforming methane according to an embodiment of the present disclosure is advantageous in that the elution of metals constituting the porous metal support may be prevented during the preparation of the catalyst for reforming methane since a film of the oxides of the metals constituting the porous metal support is formed on the surface of the porous metal support through oxidation. In addition, the catalyst for reforming methane according to an embodiment of the present disclosure can further prevent the exposure of the components such as NiO, CrO$_x$, etc. from the oxide film because the coating layer 1 containing the first inorganic oxide is further formed on the metal oxide film constituting the porous metal support by ALD (atomic layer deposition).

**Claims**

1. A method for preparing a catalyst for reforming methane, comprising:

    a step of oxidizing the surface of a porous metal support;
    a step of forming a coating layer 1 comprising a first inorganic oxide on the porous metal support with the surface oxidized by ALD (atomic layer deposition), and then preparing a catalyst precursor provided with the coating layer 1 by performing a first heat treatment process; and

a step of coating a solution comprising a precursor of a perovskite-based compound represented by Chemical Formula 1 on the catalyst precursor provided with the coating layer 1, and then preparing a catalyst provided with a coating layer 2 by performing a second heat treatment process:

[Chemical Formula 1] $\quad Sr_{1-x}A_xTi_{1-y}B_yO_{3-\delta}$

wherein
A is selected from Y, Sc, La and lanthanide series elements,
B is Cr, Mn, Fe, Co, Ni, Mo, Ru or Rh,
$x$ is a real number which is 0 or greater and smaller than 1,
$y$ is a real number which is 0 or greater and smaller than 1,
$\delta$ is a real number which is 0 or greater and smaller than 1, and
$(x + y) > 0$ is satisfied.

2. The method for preparing a catalyst for reforming methane according to claim 1, wherein the porous metal support is a metal foam comprising NiCrAlFe, NiCrAl, SiC or $\alpha$-$Al_2O_3$.

3. The method for preparing a catalyst for reforming methane according to claim 1, wherein, in the step of oxidizing the surface of the porous metal support, the porous metal support is oxidized in the air at 800 °C to 1,200 °C for 2 hours or shorter.

4. The method for preparing a catalyst for reforming methane according to claim 1, which further comprises, before forming the coating layer 1 comprising the first inorganic oxide, a step of forming a coating layer 1-1 comprising a second inorganic oxide on the porous metal support with the surface oxidized by dip coating, wherein the coating layer 1 comprising the first inorganic oxide is formed on the coating layer 1-1 comprising the second inorganic oxide.

5. The method for preparing a catalyst for reforming methane according to claim 4, wherein the step of forming the coating layer 1-1 comprising the second inorganic oxide comprises: a step of coating a solution comprising the precursor of the second inorganic oxide on the porous metal support with the surface oxidized by dip coating; and a step of performing a third heat treatment process.

6. The method for preparing a catalyst for reforming methane according to claim 1, which further comprises, after forming the coating layer 1 comprising the first inorganic oxide, a step of forming a coating layer 1-1 comprising a second inorganic oxide by dip coating, wherein the coating layer 2 is formed on the coating layer 1-1.

7. The method for preparing a catalyst for reforming methane according to claim 4 or 6, wherein each of the coating layer 1 and the coating layer 1-1 independently comprises an inorganic oxide comprising one or more of Al, Ce, Zr, Y, Ti and Si.

8. The method for preparing a catalyst for reforming methane according to claim 4 or 6, wherein each of the coating layer 1 and the coating layer 1-1 independently comprises one or more selected from $AlO_x$ ($0 < x \leq 1.6$), $Al_2O_3$, $ZrO_2$ and $ZrAl_xO_y$ ($1 < x < 3$, $3 < y < 9$).

9. The method for preparing a catalyst for reforming methane according to claim 1, wherein Chemical Formula 1 is represented by Chemical Formula 2 or 3:

[Chemical Formula 2] $\quad SrTi_{1-y}B_yO_{3-\delta}$

[Chemical Formula 3] $\quad Sr_{1-x}Y_xTi_{1-y}B_yO_{3-\delta}$

wherein

B is Ni or Rh,
$x$ is a real number which is 0 or greater and smaller than 1,
$y$ is a real number which is 0 or greater and smaller than 1, and
$\delta$ is a real number which is 0 or greater and smaller than 1.

10. The method for preparing a catalyst for reforming methane according to claim 1, wherein the solution comprising the precursor of the perovskite-based compound represented by Chemical Formula 1 is coated on the catalyst precursor provided with the coating layer 1 by dip coating.

11. A catalyst for reforming methane, comprising:

   a porous metal support with the surface oxidized;
   a coating layer 1 provided on the porous metal support with the surface oxidized and comprising a first inorganic oxide; and
   a coating layer 2 provided on the coating layer 1 and comprising a perovskite-based compound represented by Chemical Formula 1, wherein
   the coating layer 1 has a thickness of 5 nm to 100 nm, and
   the thickness uniformity (%) of the coating layer 1 calculated by Equation 4 is 60% or higher:

   (Minimum thickness of coating layer 1) / (maximum thickness of coating layer 1) x 100          [Equation 4]

   [Chemical Formula 1]          $Sr_{1-x}A_xTi_{1-y}B_yO_{3-\delta}$
   wherein
   A is selected from Y, Sc, La and lanthanide series elements,
   B is Cr, Mn, Fe, Co, Ni, Mo, Ru or Rh,
   x is a real number which is 0 or greater and smaller than 1,
   y is a real number which is 0 or greater and smaller than 1,
   $\delta$ is a real number which is 0 or greater and smaller than 1, and
   $(x + y) > 0$ is satisfied.

12. The catalyst for reforming methane according to claim 11, which further comprises a coating layer 1-1 comprising a second inorganic oxide between the porous metal support with the surface oxidized and the coating layer 1; or between the coating layer 1 and the coating layer 2.

13. The catalyst for reforming methane according to claim 12, wherein each of the coating layer 1 and the coating layer 1-1 independently comprises an inorganic oxide comprising one or more of Al, Ce, Zr, Y, Ti and Si.

14. The catalyst for reforming methane according to claim 12, wherein each of the coating layer 1 and the coating layer 1-1 independently comprises one or more selected from $AlO_x$ ($0 < x \le 1.6$), $Al_2O_3$, $ZrO_2$ and $ZrAl_xO_y$ ($1 < x < 3$, $3 < y < 9$).

【FIG. 1】

# INTERNATIONAL SEARCH REPORT

| International application No. |
| --- |
| **PCT/KR2025/002903** |

| A. | CLASSIFICATION OF SUBJECT MATTER |
| --- | --- |

**B01J 37/02**(2006.01)i; **B01J 23/83**(2006.01)i; **B01J 37/08**(2006.01)i; **B01J 23/00**(2006.01)i; **C23C 16/455**(2006.01)i; **C01B 3/40**(2006.01)i

According to International Patent Classification (IPC) or to both national classification and IPC

| B. | FIELDS SEARCHED |
| --- | --- |

Minimum documentation searched (classification system followed by classification symbols)

B01J 37/02(2006.01); B01J 21/04(2006.01); B01J 21/06(2006.01); B01J 23/00(2006.01); B01J 23/22(2006.01); B01J 23/74(2006.01); B01J 23/86(2006.01); B01J 35/04(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 촉매(catalyst), 메탄(methane), 페로브스카이트(perovskite), ALD(atomic layer deposition)

| C. | DOCUMENTS CONSIDERED TO BE RELEVANT |
| --- | --- |

| Category* | Citation of document, with indication, where appropriate, of the relevant passages | Relevant to claim No. |
| --- | --- | --- |
| Y | KR 10-2023-0073077 A (LG CHEM, LTD.) 25 May 2023 (2023-05-25)<br>claims 1-8; paragraphs [0091]-[0099] | 1-14 |
| Y | JP 06-020557 B2 (EMITEC GESELLSCHAFT FUR EMISSIONSTECHNOLOGIE MBH) 23 March 1994 (1994-03-23)<br>claim 1 | 1-14 |
| Y | KR 10-2020-0038716 A (UNIST(ULSAN NATIONAL INSTITUTE OF SCIENCE AND TECHNOLOGY) et al.) 14 April 2020 (2020-04-14)<br>claim 5 | 1-14 |
| Y | KR 10-2002-0080387 A (BATTELLE MEMORIAL INSTITUTE) 23 October 2002 (2002-10-23)<br>paragraphs [0003]-[0032] | 4-8,12-14 |

☑ Further documents are listed in the continuation of Box C.    ☑ See patent family annex.

| * | Special categories of cited documents: |
| --- | --- |
| "A" | document defining the general state of the art which is not considered to be of particular relevance |
| "D" | document cited by the applicant in the international application |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
| --- | --- |
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
| --- | --- |
| **23 June 2025** | **23 June 2025** |

| Name and mailing address of the ISA/KR | Authorized officer |
| --- | --- |
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

## INTERNATIONAL SEARCH REPORT

International application No.

**PCT/KR2025/002903**

**C.    DOCUMENTS CONSIDERED TO BE RELEVANT**

| Category* | Citation of document, with indication, where appropriate, of the relevant passages | Relevant to claim No. |
|---|---|---|
| A | KR 10-2019-0067146 A (INDUSTRY FOUNDATION OF CHONNAM NATIONAL UNIVERSITY) 14 June 2019 (2019-06-14)<br>claims 1-9 | 1-14 |

## INTERNATIONAL SEARCH REPORT
### Information on patent family members

International application No.

**PCT/KR2025/002903**

| Patent document cited in search report | | | Publication date (day/month/year) | Patent family member(s) | | | Publication date (day/month/year) |
|---|---|---|---|---|---|---|---|
| KR | 10-2023-0073077 | A | 25 May 2023 | CN | 116745028 | A | 12 September 2023 |
| | | | | EP | 4257237 | A1 | 11 October 2023 |
| | | | | EP | 4257237 | A4 | 31 July 2024 |
| | | | | JP | 2024-503473 | A | 25 January 2024 |
| | | | | JP | 7648289 | B2 | 18 March 2025 |
| | | | | US | 2024-0359170 | A1 | 31 October 2024 |
| | | | | WO | 2023-090586 | A1 | 25 May 2023 |
| JP | 06-020557 | B2 | 23 March 1994 | EP | 0284804 | A1 | 05 October 1988 |
| | | | | EP | 0284804 | B1 | 30 October 1991 |
| | | | | JP | 63-236542 | A | 03 October 1988 |
| | | | | US | 4885269 | A | 05 December 1989 |
| KR | 10-2020-0038716 | A | 14 April 2020 | JP | 2022-502251 | A | 11 January 2022 |
| | | | | JP | 7189338 | B2 | 13 December 2022 |
| | | | | KR | 10-2105934 | B1 | 06 May 2020 |
| | | | | US | 12109552 | B2 | 08 October 2024 |
| | | | | US | 2021-0387166 | A1 | 16 December 2021 |
| | | | | WO | 2020-071625 | A1 | 09 April 2020 |
| KR | 10-2002-0080387 | A | 23 October 2002 | CN | 100211162 | C | 20 July 2005 |
| | | | | CN | 100400923 | A | 05 March 2003 |
| | | | | EP | 1257362 | A1 | 20 November 2002 |
| | | | | EP | 1257362 | B1 | 08 May 2013 |
| | | | | EP | 2295140 | A1 | 16 March 2011 |
| | | | | JP | 2003-520675 | A | 08 July 2003 |
| | | | | JP | 2008-520675 | A5 | 14 February 2008 |
| | | | | JP | 2012-110894 | A | 14 June 2012 |
| | | | | JP | 4982717 | B2 | 25 July 2012 |
| | | | | JP | 5964594 | B2 | 03 August 2016 |
| | | | | KR | 10-0670954 | B1 | 17 January 2007 |
| | | | | US | 2003-0007904 | A1 | 09 January 2003 |
| | | | | US | 2004-0188326 | A1 | 30 September 2004 |
| | | | | US | 6440895 | B1 | 27 August 2002 |
| | | | | US | 6762149 | B2 | 13 July 2004 |
| | | | | US | 7498001 | B2 | 03 March 2009 |
| | | | | WO | 01-54812 | A1 | 02 August 2001 |
| | | | | WO | 01-54812 | B1 | 29 November 2001 |
| KR | 10-2019-0067146 | A | 14 June 2019 | KR | 10-2092736 | B1 | 04 May 2020 |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 1020240031318

- KR 1020240031322